# EUROPEAN PATENT APPLICATION

(11) **EP 2 423 967 A2**
(43) Date of publication of application: **29.02.2012**
(21) Application number: 11151969.0
(22) Date of filing: 25.01.2011
(51) Int. Cl.: H01L 31/0224

(54) **Solar cell and method of manufacturing the same**

(30) Priority: 25.08.2010 KR 20100082577
(71) Applicant: SAMSUNG ELECTRONICS CO., LTD., Suwon-si, Gyeonggi-do (KR); Samsung SDI Co., Ltd., Gyeonggi-do (KR)
(72) Inventor: Xianyu, Wenxu, Gyeonggi-do (KR); Park, Yong-Young, Daejeon (KR); Kim, Yeon-Hee, Seoul (KR); Yang, Woo-Young, Gyeonggi-do (KR); Kim, Hyun-Jong, Seoul (KR)
(74) Representative: Taor, Simon Edward William

(57) **Abstract**

A solar cell including: a semiconductor substrate 110, a passivation film 130 disposed on a side of the semiconductor substrate, a protective layer 140 disposed on a side of the passivation film opposite the semiconductor substrate, and an electrode 150 disposed on a side of the protective layer opposite the passivation film, wherein the electrode includes a product of a conductive paste including glass frit and a conductive material, and wherein the protective layer includes a material having an absolute value of a Gibb's free energy which is less than an absolute value of a Gibb's free energy of each component of the glass frit.

## Description

### BACKGROUND

### 1. Field

This disclosure relates to a solar cell and a method of manufacturing the same.

### 2. Description of the Related Art

A solar cell is a photoelectric conversion device that converts solar energy to electrical energy. Solar cells are of interest as an essentially unlimited, non-polluting next generation energy source.

A solar cell includes p-type semiconductors and n-type semiconductors. When a solar cell absorbs solar energy in a photoactive layer, electron-hole pairs ("EHP") are produced in the n- and p-type semiconductors, and the produced electrons and holes move to the n-type semiconductor and the p-type semiconductor, respectively, and are collected at electrodes to provide electrical energy.

There remains a need to increase solar cell efficiency so that a solar cell may output as much electrical energy as possible from a given amount of solar energy. To increase solar cell efficiency, it would be desirable to reduce losses, such as resistive losses associated with contacts or collectors of the produced electric charge, as well as to improve production of electron-hole pairs in the semiconductor materials.

One cause of electric charge loss is electric charge dissipation by recombination of produced electrons and holes. To prevent recombination of electrons and holes, a passivation film may be positioned on a rear side of a solar cell. There remains a need for an improved passivation layer that more effectively prevents recombination of electrons and holes.

### SUMMARY

An exemplary embodiment provides a solar cell in which the properties of a passivation film are improved to improve the efficiency of the solar cell.

Another embodiment provides a method of manufacturing the solar cell.

According to an embodiment, disclosed is a solar cell including a semiconductor substrate, a passivation film disposed on a side of the semiconductor substrate, a protective layer disposed on a side of the passivation film opposite the semiconductor substrate, and an electrode disposed on a side of the protective layer opposite the passivation film, wherein the electrode includes a product of a conductive paste including a glass frit and a conductive material, wherein the protective layer includes a material having an absolute value of a Gibb's free energy which is less than an absolute value of a Gibb's free energy of each component of the glass frit.

The protective layer may include copper (Cu), palladium (Pd), iridium (Ir), an alloy thereof, or an oxide thereof, or a combination thereof.

The alloy may include a copper-aluminum (Cu-Al) alloy, a palladium-aluminum (Pd-Al) alloy, or an iridium-aluminum (Ir-Al) alloy, or a combination thereof.

The alloy may include about 0.1 to about 20 atomic percent (at%) aluminum, based on 100 at% of the alloy.

The glass frit may include PbO, ZnO, SiO₂, B₂O₃, Bi₂O₃, BaO, Na₂O, or a combination thereof.

The passivation film may include aluminum oxide.

The passivation film and the protective layer may define a through hole, and the electrode may contact the semiconductor substrate through the through hole of the passivation film and the protective layer.

The electrode may contact the passivation film only in the through hole of the passivation film and the protective layer.

The protective layer may have a thickness of about 5 to about 500 nanometers (nm).

According to another embodiment, disclosed is a method of manufacturing a solar cell, including: forming a passivation film on a side of a semiconductor substrate, forming a protective layer on a side of the passivation film opposite the semiconductor substrate, forming a through hole in the protective layer and the passivation film, and forming an electrode which contacts the semiconductor substrate through the through hole of the protective layer and the passivation film, wherein the electrode includes a product of a conductive paste including a glass frit and a conductive material, and the protective layer includes a material having an absolute value of Gibb's free energy which is less than an absolute value of Gibb's free energy of each component of the glass frit.

The protective layer may include copper (Cu), palladium (Pd), iridium (Ir), an alloy thereof, or an oxide thereof, or a combination thereof.

The alloy may include a copper-aluminum (Cu-Al) alloy, a palladium-aluminum (Pd-Al) alloy, or an iridium-aluminum (Ir-Al) alloy, or a combination thereof.

The glass frit may include PbO, ZnO, SiO₂, B₂O₃, Bi₂O₃, BaO, Na₂O, or a combination thereof.

The forming of the through hole in the protective layer and the passivation film may be carried out by laser ablation with a laser having a wavelength of about 300 to about 600 nm.

The forming of the electrode may include screen printing the conductive paste, and heat treating the conductive paste.

### BRIEF DESCRIPTION OF THE DRAWINGS

The above and other aspects, advantages and features of this disclosure will become more apparent by describing in further detail exemplary embodiments thereof with reference to the accompanying drawings, in which:
FIG. 1 is a cross-sectional view of an embodiment of a solar cell; and
FIG. 2 to FIG. 8 are cross-sectional views sequentially showing an embodiment of a method of manufacturing an embodiment of a solar cell.

### DETAILED DESCRIPTION

Embodiments will hereinafter be described in further detail referring to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

It will be understood that, although the terms "first," "second," "third," etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, the singular forms "a," "an," and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath," "below," "lower," "above," "upper," "up," "down," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

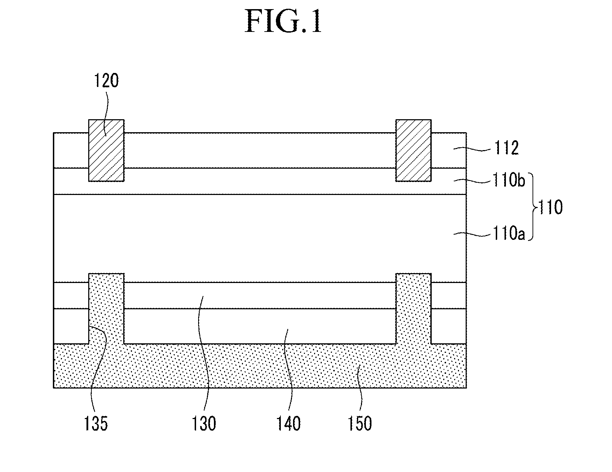

First, a solar cell according to an embodiment will be disclosed with reference to FIG. 1.

FIG. 1 is a cross-sectional view of an embodiment of a solar cell.

Hereinafter, a solar energy receiving side of a semiconductor substrate 110 is referred to as a front side, and a side which is opposite to the front side of the semiconductor substrate 110 is referred to as a rear side. Further, hereinafter, for better understanding and ease of description, spatial relationships (e.g., upper or lower) will be with respect to the semiconductor substrate 110 as a center, but are not limited thereto.

The solar cell according to this embodiment includes a semiconductor substrate 110 including a lower semiconductor layer 110a and an upper semiconductor layer 110b.

The semiconductor substrate 110 may comprise crystalline silicon or a compound semiconductor, and if the semiconductor substrate 110 consists of crystalline silicon, as an example, a silicon wafer may be used. One of the lower semiconductor layer 110a and the upper semiconductor layer 110b may be a p-type impurity doped semiconductor layer, and the other may be an n-type impurity doped semiconductor layer. The p-type impurity may be a Group III element such as boron (B), and the n-type impurity may be a Group V element such as phosphorous (P), for example.

The surface of the semiconductor substrate 110 may be surface textured. The surface textured semiconductor substrate 110 may have protrusions and depressions. The shape of such protrusions and depressions is not particularly limited, and may be regular or irregular. A combination of different shapes can be used, such as a pyramidal, rectangular, cubic, spherical, ovoid, or other shape. The semiconductor substrate may have a porous structure having a honeycomb shape, for example. The surface textured semiconductor substrate 110 may increase the surface area to increase the light absorption rate and reduce reflectance, thereby improving solar cell efficiency.

On the front side of the semiconductor substrate 110, an anti-reflection coating 112 may be disposed. The anti-reflection coating 112 may comprise a material which is substantially transparent and is insulating. The anti-reflection coating 112 may comprise, consist essentially of, or consist of, for example, silicon nitride (SiNₓ), silicon oxide (SiO₂), titanium oxide (TiO₂), aluminum oxide (AI₂O₃), magnesium oxide (MgO), cerium oxide (CeO₂), or a combination thereof, and it may be in the form of a single layer or multiple layers.

The anti-reflection coating 112 may have a thickness of about 200 to about 1500 angstroms (A), specifically about 300 to about 1400 A, more specifically about 400 to about 1300 A.

The anti-reflection coating 112 may be disposed (e.g., formed) on the front side of the semiconductor substrate 110, which is the side that receives solar energy, so as to reduce reflectance of light and increase selectivity of a specific wavelength region. Further, the anti-reflection coating 112 may improve the contact properties (e.g., contact resistance) with silicon present at the surface of the semiconductor substrate 110 to increase the efficiency of the solar cell.

On the anti-reflection coating 112, a plurality of front electrodes 120 is disposed (e.g., formed). The front electrodes 120 may extend along a direction of the semiconductor substrate 110, and penetrates through the anti-reflection coating 112 to contact the upper semiconductor layer 110b. The front electrodes 120 may comprise a low resistance metal, such as silver (Ag), or the like, and it may have a configuration, e.g., a grid pattern to reduce shadowing loss and sheet resistance.

On the rear side of the semiconductor substrate 110, a passivation film 130 is disposed (e.g., formed).

The passivation film 130 may substantially or entirely prevent electric charges produced in the semiconductor substrate 110 from moving to the rear side of the semiconductor substrate 110. Specifically, the passivation film 130 may comprise a dielectric material having a plurality of negative fixed charges at a surface thereof. While not wanting to be bound by theory, it is believed that the negative fixed charges of the dielectric material may disturb or prevent movement (e.g., transport) of electrons present in the lower semiconductor layer 110a to the rear side of the semiconductor substrate 110, such that recombination of electrons and holes on the rear side of the semiconductor substrate 110 may be substantially or entirely prevented, thus reducing electric charge loss, and thereby improving solar cell efficiency.

The passivation film 130 may comprise, for example, an aluminum oxide, e.g., AlOₓ, wherein x is about 1 to about 2, specifically about 1.5.

On a side of the passivation film 130 opposite the semiconductor substrate 110, a protective layer 140 is disposed (e.g., formed).

The protective layer 140 protects the passivation film 130. The protective layer 140 may comprise a metal, a metal alloy, or an oxide thereof. The protective layer 140 may have a thickness of about 5 to about 500 nanometers (nm), specifically about 10 to about 400 nm, more specifically about 20 to about 300 nm, and will be discussed in further detail below.

The passivation film 130 and the protective layer 140 define a through hole 135. As shown in FIG. 1, in an embodiment, a plurality of through-holes can be present.

On a side of the protective layer 140, a rear electrode 150 is disposed (e.g., formed).

The rear electrode 150 may comprise an opaque metal such as aluminum (Al). Also, the rear electrode 150 may comprise the product of a conductive paste, which may be formed from using a conductive paste that may include a glass frit as described in further detail below and a conductive material such as aluminum (Al). The components and relative amounts of the components in such pastes are known in the art.

The rear electrode 150 includes a first portion contacting the lower semiconductor layer 110a through the through holes 135, and a second portion disposed (e.g., formed) over the surface of the rear side of the semiconductor substrate 110. The second portion may be directly on the protective layer 140.

In the rear electrode 150, a back surface field ("BSF") may be produced in the portion of the rear electrode 150 that contacts the lower semiconductor layer 110a. A back surface field is an internal electric field formed between the lower semiconductor layer 110a and the rear electrode 150 when, for example, silicon (Si) of the lower semiconductor layer 110a and aluminum (Al) of the rear electrode 150 contact each other, and aluminum functions as p-type impurity. Thus, while not wanting to be bound by theory, it is believed that the BSF may prevent transport of electrons to the rear side of the semiconductor substrate 110. By preventing transport of electrons to the rear side of the semiconductor substrate 110, recombination and dissipation of electric charge on the rear side of the semiconductor substrate 110 may be prevented or reduced, thereby increasing solar cell efficiency.

In the rear electrode 150, the portion of the rear electrode 150 disposed over the surface of the rear side of the semiconductor substrate 110 (e.g., the portion on the protective layer 140) may reflect light passing through the semiconductor substrate 110 back to the semiconductor substrate, thereby preventing or reducing light leakage and thereby increasing solar cell efficiency.

Hereinafter, the protective layer 140 will be disclosed in further detail.

The protective layer 140, as further explained above, is disposed between the passivation film 130 and the rear electrode 150, and protects the passivation film 130 from the rear electrode 150.

Thus, the passivation film 130 and the rear electrode 150 desirably do not directly contact because the protective layer 140 effectively protects the passivation film 130. Direct contact between the passivation film 130 and the rear electrode 150 can undesirably alter the passivation characteristic of the passivation film 130, for example if the passivation film 130 is contacted by the glass frit contained in the conductive paste for the rear electrode during a firing process of the rear electrode 150.

Thus, during the heat treatment process, which may include a firing process of the rear electrode 150, the rear electrode 150 desirably does not penetrate the protective layer 140.

As described above, the rear electrode 150 may be formed by disposing a conductive paste that comprises a glass frit and a conductive material, and then the rear electrode 150 may be formed by heat treating (e.g., firing) the conductive paste. At the high temperatures used during heat treating, the glass frit may easily react with or combine with other materials in contact with the glass frit.

The protective layer 140 comprises a material having an absolute value of a Gibb's free energy which is less than an absolute value of a Gibb's free energy of each component of the glass frit. In an embodiment, the protective layer 140 consists of a material having an absolute value of a Gibb's free energy which is less than an absolute value of a Gibb's free energy of each component of the glass frit. In another embodiment, the protective layer 140 comprises, consists essentially of, or consists of a material having an absolute value of a Gibb's free energy which is less than an absolute value of a Gibb's free energy of the glass frit. The material of the protective layer 140 does not substantially react with the glass frit even at a high temperature. Thus in an embodiment the material of the protective layer is effectively inert to the components of the glass frit, and in another embodiment the protective layer 140 is effectively inert towards the glass frit.

The glass frit may comprise PbO, ZnO, SiO₂, B₂O₃, Bi₂O₃, BaO, Na₂O, or a combination thereof. The glass frit may comprise, for example, a PbO-SiO₂-frit, a PbO-SiO₂-B₂O₃-frit, a PbO-SiO₂-B₂O₃-ZnO-frit, a PbO-SiO₂-B₂O₃-BaO-frit, a PbO-SiO₂-ZnO-BaO-frit, a ZnO-SiO₂-frit, a ZnO-B₂O₃-SiO₂-frit, a ZnO-K₂O-B₂O₃-SiO₂-BaO-frit, a Bi₂O₃-SiO₂-frit, a Bi₂O₃-B₂O₃-SiO₂-frit, a Bi₂O₃-B₂O₃-SiO₂-BaO-frit, a ZnO-BaO-B₂O₃-P₂O₅-Na₂O-frit, or a Bi₂O₃-B₂O₃-SiO₂-BaO-ZnO-frit, or a combination thereof.

In an embodiment, the protective layer 140 may comprise, consist essentially of, or consist of a material having an absolute value of a Gibb's free energy which is less than an absolute value of a Gibb's free energy of the glass frit, i.e., PbO, ZnO, SiO₂, B₂O₃, Bi₂O₃, BaO, Na₂O, or a combination thereof. The protective layer 140 may comprise, for example, copper (Cu), palladium (Pd), iridium (Ir), an alloy thereof, or a combination thereof.

The alloy may include, for example, a copper-aluminum (Cu-Al) alloy, a palladium-aluminum (Pd-Al) alloy, or an iridium-aluminum (Ir-Al) alloy, or a combination thereof. While not wanting to be bound by theory, it believed that aluminum (Al) may improve adhesion of the protective layer 140 to adjacent layers, and may simultaneously prevent or reduce oxidation of copper (Cu), palladium (Pd), or iridium (Ir), an alloy thereof, or a combination thereof.

The alloy may include about 0.1 to about 20 atomic percent (at%), specifically 0.5 to 15 at%, more specifically 1 to 10 at% aluminum (Al), based on 100 atomic percent of the alloy. If aluminum is included in the above range, it may prevent oxidation of copper (Cu), palladium (Pd), or iridium (Ir), and it may improve adhesion to an adjacent layer while sufficiently protecting the contents thereof from degradation, such as oxidation.

Further, because the copper (Cu), palladium (Pd), iridium (Ir), or alloy thereof, or combination thereof may be oxidized to some extent during the heat treating (e.g., firing) process, manufacturing process, or the like, an oxide thereof may be at least partly included in the protective layer 140.

As explained above, the protective layer 140 prevents direct contact between the passivation film 130 and the rear electrode 150. Thereby, the rear electrode 150 directly contacts the passivation film 130 only at a portion in the through hole 135, and does not otherwise contact the passivation film 130. Thus, the passivation properties of passivation film 130 may be maintained over the surface of the passivation film 130 opposite the semiconductor substrate 110 to prevent loss of electric charge.

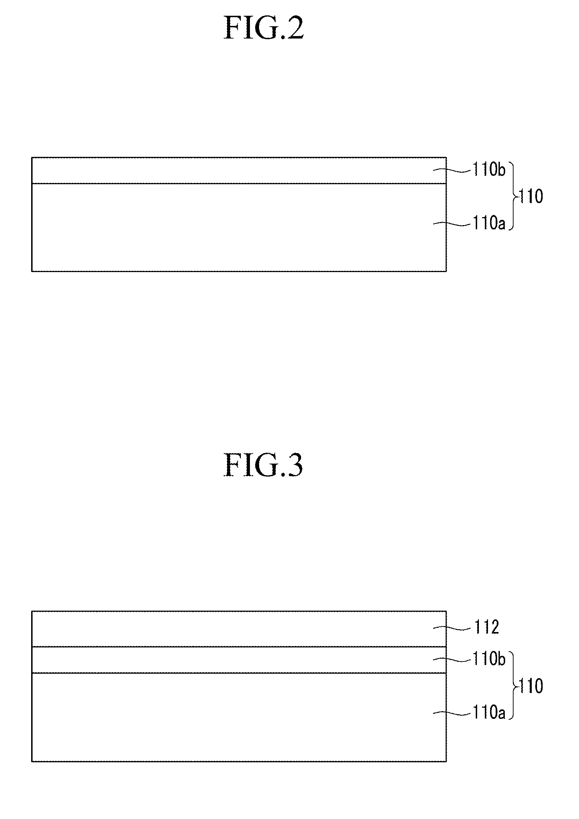

Hereinafter, a manufacturing method of the solar cell according to an embodiment is further disclosed while referring to FIG. 2 to FIG. 8 together with FIG. 1.

FIG. 2 to FIG. 8 are cross-sectional views sequentially showing an embodiment of a manufacturing method of an embodiment of the solar cell.

First, a semiconductor substrate 110, such as a silicon wafer, is prepared. The semiconductor substrate 110 may be doped with a p-type impurity, for example.

Subsequently, the semiconductor substrate 110 is surface textured. The surface texturing may be performed by a wet method using a strong acid solution, such as nitric acid or hydrofluoric acid, or a strong base solution such as sodium hydroxide, or by a dry method, such as plasma treatment.

Then, referring to FIG. 2, the semiconductor substrate 110 is doped with an n-type impurity, for example. The n-type impurity may be doped by diffusing POCl₃, or H₃PO₄, or the like at a high temperature. The semiconductor substrate 110 thus formed includes a lower semiconductor layer 110a and an upper semiconductor layer 110b doped with different impurities.

Then, referring to FIG. 3, on the front side of the semiconductor substrate 110, an anti-reflection coating 112, which may also be an insulation layer, is disposed (e.g., formed). The anti-reflection coating 112 may be formed by plasma enhanced chemical vapor deposition ("PECVD") of silicon nitride, or the like.

Subsequently, an n-type impurity remaining on the rear side of the semiconductor substrate 110 is removed.

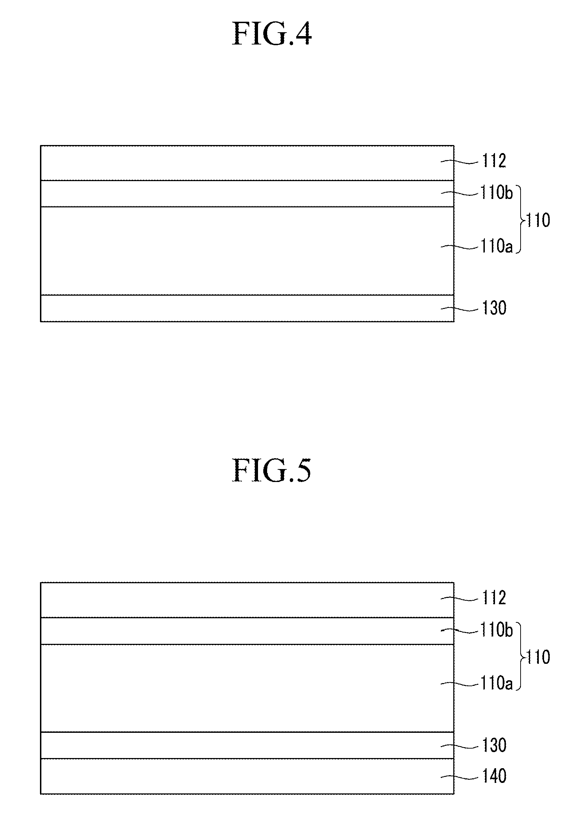

Then, referring to FIG. 4, on the rear side of the semiconductor substrate 110, a passivation film 130 comprising, for example, aluminum oxide is formed. The passivation film 130 may be formed by chemical vapor deposition ("CVD"), for example.

Then, referring to FIG. 5, on a side of the passivation film 130 opposite the semiconductor substrate 110, a protective layer 140 is disposed (e.g., formed). The protective layer 140, as further disclosed above, may comprise a material having low reactivity, for example copper (Cu), palladium (Pd), iridium (Ir), or an alloy thereof, or a combination thereof, and it may be formed by, for example, sputtering or chemical vapor deposition ("CVD"). The alloy may include a copper-aluminum (Cu-Al) alloy, a palladium-aluminum (Pd-Al) alloy, or an iridium-aluminum (Ir-Al) alloy, or a combination thereof.

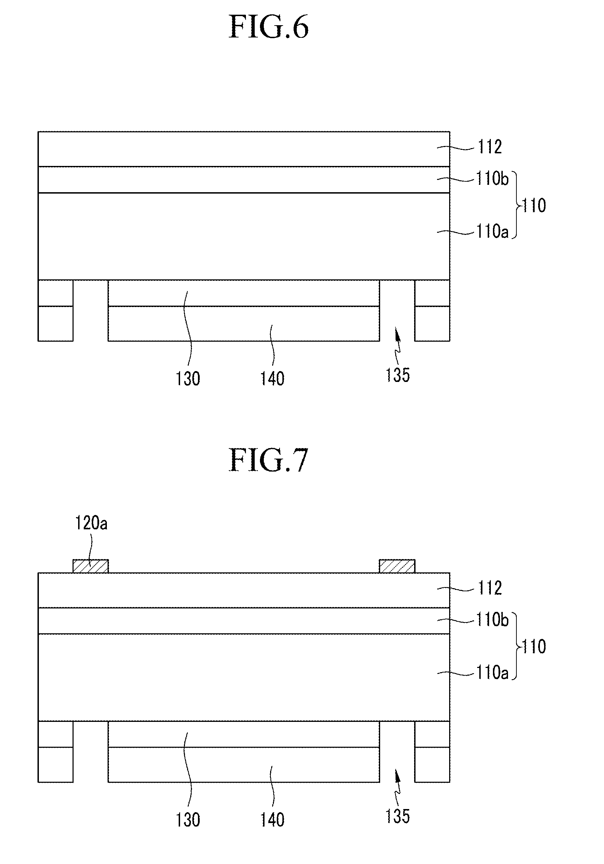

Then, referring to FIG. 6, a portion of the protective layer 140 and the passivation film 130 are removed to form a through hole 135 in the protective layer 140 and the passivation film 130, thereby exposing a portion of the lower semiconductor layer 110a. The protective layer 140 and the passivation film 130 may be removed by, for example, laser ablation with a laser having a wavelength of about 300 to about 600 nanometers (nm), specifically about 350 to 550 nm, more specifically about 400 to about 500 nm. The through hole 135 may be formed in the protective layer 140 and the passivation film 130 using separate lasers, or it may be formed therein at one time using a single laser.

Then, referring to FIG. 7, on a side of the anti-reflection coating 112 opposite the semiconductor substrate 110, a conductive paste 120a for a front electrode is applied.

The conductive paste 120a for a front electrode may include a metal powder comprising silver (Ag), or the like. Further, the front electrode may be formed by screen printing, wherein the conductive paste is applied on the position where the front electrode is to be formed and dried.

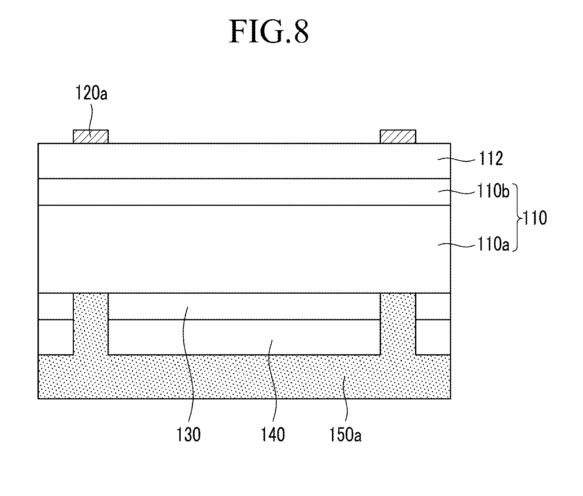

Then, referring to FIG. 8, on a side of the protective layer 140 opposite the semiconductor substrate 110, a conductive paste 150a for a rear electrode is applied. The conductive paste 150a for a rear electrode may be applied so as to fill the through holes 135 first and then cover the surface of the protective layer 140.

The conductive paste 150a for a rear electrode may comprise glass frit and a conductive material, such as aluminum (Al), or the like. Further, the rear electrode may be formed by screen printing, in which the conductive paste is applied on the position where the rear electrode is to be formed and dried.

Subsequently, the semiconductor substrate 110 on which the conductive paste 120a for a front electrode and the conductive paste 150a for a rear electrode are applied is placed in a high temperature furnace and fired. The firing may be performed at a temperature which is higher than the fusion temperature of the metal powder, for example at about 600°C to about 1000°C, specifically about 650°C to about 950°C, more specifically about 700°C to about 900°C. In another embodiment, the conductive paste 120a for a front electrode and the conductive paste 150a for a rear electrode may be fired separately, without limitation.

Then, referring to FIG. 1, as a result of the firing, the conductive paste 120a for a front electrode penetrates through the anti-reflection coating 112 to contact the upper semiconductor layer 110b, and the conductive paste 150a for a rear electrode contacts the lower semiconductor layer 110a through the through hole 135 formed in the passivation film 130 and the protective layer 140.

While this disclosure has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A solar cell comprising:
a semiconductor substrate (110);
a passivation film (130) disposed on a side of the semiconductor substrate;
a protective layer (140) disposed on a side of the passivation film opposite the semiconductor substrate; and
an electrode (150) disposed on a side of the protective layer opposite the passivation film,
wherein the electrode (150) comprises a product of a conductive paste comprising glass frit and a conductive material, and
wherein the protective layer (140) comprises a material having an absolute value of a Gibb's free energy which is less than an absolute value of a Gibb's free energy of each component of the glass frit.

2. The solar cell of claim 1, wherein the protective layer (140) comprises copper, palladium, iridium, an alloy thereof, or an oxide thereof, or a combination thereof.

3. The solar cell of claim 2, wherein protective layer (140) comprises an alloy, the alloy comprising a copper-aluminum alloy, a palladium-aluminum alloy, or an iridium-aluminum alloy, or a combination thereof.

4. The solar cell of claim 3, wherein the alloy comprises 0.1 to 20 atomic percent aluminum, based on 100 atomic percent of the alloy.

5. The solar cell of any preceding claim, wherein the glass frit comprises PbO, ZnO, SiO₂, B₂O₃, Bi₂O₃, BaO, Na₂O, or a combination thereof.

6. The solar cell of any preceding claim, wherein the passivation film (140) comprises aluminum oxide.

7. The solar cell of any preceding claim, wherein the passivation film (130) and the protective layer (140) comprise a through hole (135), and the electrode (150) contacts the semiconductor substrate through the through hole (!35) of the passivation film and the protective layer.

8. The solar cell of claim 7, wherein the electrode (150) contacts the passivation film (130) only via the through hole (135) of the passivation film and the protective layer.

9. The solar cell of claim 1, wherein the protective layer (140) has a thickness of 5 to 500 nanometers.

10. A method of manufacturing a solar cell, comprising:
forming a passivation film (130) on a side of a semiconductor substrate (110);
forming a protective layer (140) on a side of the passivation film opposite the semiconductor substrate;
forming a through hole (135) in the protective layer (140) and the passivation film (130); and
forming an electrode (150) which contacts the semiconductor substrate (110) through the through hole (135) of the protective layer (140) and the passivation film (130),
wherein the electrode (150) comprises a product of a conductive paste comprising a glass frit and a conductive material, and
the protective layer (140) comprises a material having an absolute value of a Gibb's free energy less than an absolute value of a Gibb's free energy of each component of the glass frit.

11. The method of claim 10, wherein the protective layer (140) comprises copper, palladium, iridium, an alloy thereof, or an oxide thereof, or a combination thereof.

12. The method of claim 11, wherein the protective layer (140) comprises an alloy, and the alloy comprises a copper-aluminum alloy, a palladium-aluminum alloy, or an iridium-aluminum alloy, or a combination thereof.

13. The method of claim 10, 11 or 12 wherein the glass frit comprises PbO, ZnO, SiO₂, B₂O₃, Bi₂O₃, BaO, Na₂O, or a combination thereof.

14. The method of claim 10, 11, 12 or 13 wherein the forming of the through hole (130) in the protective layer and the passivation film is carried out by laser ablation with a laser having a wavelength of 300 to 600 nanometers.

15. The method of claim 10, 11, 12, 13 or 14 wherein the forming of the electrode (150) comprises:
screen printing the conductive paste, and
heat-treating the conductive paste.
